# EUROPÄISCHE PATENTSCHRIFT

(11) **EP 0 807 331 B1**
(45) Veröffentlichungstag und Bekanntmachung des Hinweises auf die Patenterteilung: **10.01.2001**
(21) Anmeldenummer: 96945532.8
(22) Anmeldetag: 25.10.1996
(51) Int. Cl.: H03G 3/00

(54) **RUNDFUNKEMPFÄNGER MIT EINEM POTENTIOMETER ALS LAUTSTÄRKEREGLER**
RADIO RECEIVER WITH A POTENTIOMETER AS VOLUME REGULATOR
RECEPTEUR RADIO EQUIPE D'UN POTENTIOMETRE COMME REGULATEUR DU VOLUME

(30) Priorität: 30.11.1995 DE 19544657
(43) Veröffentlichungstag der Anmeldung: 19.11.1997
(73) Patentinhaber: ROBERT BOSCH GMBH, 70442 Stuttgart (DE)
(72) Erfinder: GROEGER, Klaus-Erwin, D-31199 Diekholzen (DE)
(86) Internationale Anmeldenummer: DE9602036
(87) Internationale Veröffentlichungsnummer: WO9720386

(56) Entgegenhaltungen:
- US-A- 4 706 294
- PATENT ABSTRACTS OF JAPAN vol. 009, no. 106 (E-313), 10.Mai 1985 & JP 59 230311 A (MITSUBISHI DENKI KK), 24.Dezember 1984,
- PATENT ABSTRACTS OF JAPAN vol. 012, no. 265 (E-637), 23.Juli 1988 & JP 63 048905 A (MATSUSHITA ELECTRIC IND CO LTD), 1.März 1988,

## Beschreibung

### Stand der Technik

Rundfunkempfänger mit einem Potentiometer als Lautstärkeregler sind seit langem bekannt. Üblicherweise ist mit der Lautstärkeregelung die Betätigung eines Schalters in der Stromversorgung gekoppelt und zwar in der Weise, daß beim Verstellen des Abgriffs des Potentiometers zum linken oder unteren Anschlag die Lautstärke zurückgenommen wird und danach der Schalter für die Stromversorgung betätigt wird.

Seit langem sind jedoch auch Rundfunkempfänger auf dem Markt, bei denen der Schalter in der Stromversorgung und die Lautstärkeregelung getrennt voneinander zu bedienen sind. In Kraftfahrzeugen findet sich zudem die Eigenart, daß die eingebauten Autoradios über die Serienschaltung zweier Schalter an die Stromversorgung angeschlossen sind, nämlich der Serienschaltung eines Schalters im Zündschloß des Fahrzeugs und eines Schalters am Gerät.

Bei dem Ausschalten des Rundfunkempfängers mit einem vom Lautstärkesteller getrennten Schalter kann der Lautstärkeregler im ausgeschalteten Zustand des Rundfunkempfängers unbeabsichtigt zu voller Lautstärke hin verstellt werden, ohne daß dies zunächst bemerkt wird. Beim Einschalten eines solchermaßen eingestellten Rundfunkempfängers erfolgt dann die Wiedergabe des empfangenen Senders mit einer unerwünschten Lautheit.

Der nächstliegende Stand der Technik wird in US-A-4 706 294 offenbart.

Bei Verkehrsrundfunkempfängern ist es an sich bekannt, die Lautstärke während einer Verkehrsdurchsage automatisch auf eine vorgegebene Lautstärke anzuheben, wenn diese mit dem Potentiometer des Rundfunkempfängers auf leise Wiedergabe oder gar stummgeschaltet ist.

Auch die eigengesteuerte Nachführung der Lautstärke entsprechend der jeweiligen Lautheit des Fahrgeräusches im Innenraum eines Kraftfahrzeugs ist seit längerer Zeit eine bekannte Eigenschaft moderner Autoradios.

Solche Rundfunkempfänger verfügen über Mikroprozessoren, die digitale Steuersignale aufnehmen und einen NF-Steller in der Niederfrequenzstufe digital steuern.

### Vorteile der Erfindung

Mit einem Rundfunkempfänger, der die Merkmale des Anspruchs 1 aufweist, wird das Wirksamwerden einer unbeabsichtigten Verstellung des Potentiometers in der Ausschaltphase des Rundfunkempfängers verzögert bis der Hörer das Potentiometer wieder bedient, d. h. bis sich seine Hand wieder am Abgriff des Potentiometers befindet, und bis dahin unterbunden.

Die abhängigen Unteransprüche 2 bis 5 kennzeichnen verbesserte Ausführungsformen der Erfindung.

### Zeichnung

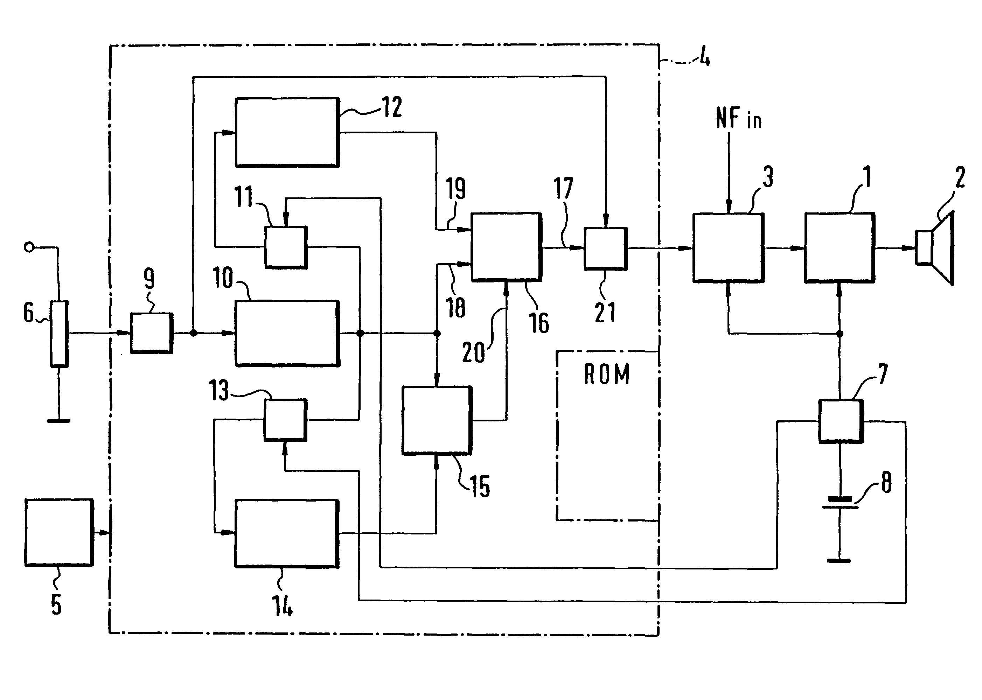

In der Zeichnung zeigt
- Fig. 1: eine mikroprozessorgesteuerte Niederfrequenzstufe eines Rundfunkempfängers.

### Beschreibung eines Ausführungsbeispiels

Die Niederfrequenzstufe in Fig. 1 umfaßt einen Endverstärker 1, der einen Lautsprecher 2 speist, über den die niederfrequente Modulation des eingestellten Senders dem Benutzer des Rundfunkempfängers zu Gehör gebracht wird. Dem Niederfrequenzverstärker 1 werden die Ausgangssignale eines digital arbeitenden NF-Stellers 3 zugeführt. An einem Steuereingang des NF-Stellers 3 ist ein Mikroprozessor 4 als Lautstärkereglerstufe angeschlossen. Von dem Mikroprozessor sind in der Zeichnung nur ausgewählte Funktionseinheiten näher dargestellt.

Die Lautstärkereglerstufe umfaßt neben dem Mikroprozessor 4 und neben Sensoren 5 für eine automatische Lautstärkeregelung - von denen ein Verkehrsfunkdecoder als Beispiel dargestellt ist - entsprechend der vorliegenden Aufgabenstellung ein Potentiometer 6 für die manuelle Einstellung der Lautstärke. Ein Schalter 7 für die Stromversorgung 8 ist getrennt vom Potentiometer bedienbar und nicht mit diesem gekoppelt. Der kann z. B. im Zündschloß liegen, wenn es sich bei dem Rundfunkempfänger um ein Autoradio handelt, und mit dem Zündschlüssel betätigt werden. Der Schalter 7 steht auch für die Stromversorgung der übrigen Bausteine der Niederfrequenzstufe und der sonstigen nicht weiter dargestellten Baugruppen des Rundfunkempfängers.

Der Abgriff des Potentiometers 6 ist mit einem A/D-Wandler 9 in einem Eingang des Mikroprozessors 4 für die manuelle Lautstärkeregelung verbunden. Der Ausgang des A/D-Wandlers 9 ist während des Ablaufs des Programms des Mikroprozessors mit einem ersten Speicher 10 z. B. einem RAM verbunden, der jeweils den momentanen Einstellwert des Potentiometers 6 digital speichert, solange die Stromversorgung eingeschaltet ist.

An den Ausgang des Speichers 10 ist über eine erste Torschaltung 11 der Eingang eines zweiten Speichers 12 anschließbar. Dieser zweite Speicher ist z. B. ein E²PROM, da in ihm, wie später noch dargelegt wird, Daten während der ganzen Ausschaltphase des Rundfunkempfängers gespeichert bleiben.

Über eine zweite Torschaltung 13 ist der Ausgang des Speichers 10 mit dem Eingang eines dritten Speichers 14 verbindbar. Der dritte Speicher 14 kann wieder von einem RAM gebildet werden.

Der Ausgang dieses dritten Speichers 14 und der Ausgang des ersten Speichers 10 werden im Programmablauf mit den beiden Eingängen einer Vergleichsstufe 15 verbunden, deren Ausgang über einen Steuereingang 20 den Umschalter 16 steuert. Der Ausgang 17 des Umschalters 16 ist über einen Tiefpaß 21 mit dem Eingang des NF-Stellers 3 für die manuelle Steuerung der Lautstärke des Rundfunkempfängers verbunden und somit auch mit dem Eingang des Endverstärkers.

Ein Eingang 18 des Umschalters 16 ist im Programmablauf mit dem Ausgang des ersten Speichers 10 verbindbar, wogegen der zweite Eingang 19 des Umschalters 16 an den Ausgang des zweiten Speichers 12 anschließbar ist.

Ein Steuereingang der ersten Torschaltung 11 erhält vom Schalter 7 im Programmablauf ein Steuersignal, wenn der Empfänger ausgeschaltet wird. Ein Steuereingang der zweiten Torschaltung 13 erhält dagegen vom Einschalter 7 ein Steuersignal, wenn der Empfänger eingeschaltet wird.

Das Mikroprozessorprogramm ist derart ausgelegt, daß die Vergleichsstufe 15 den Ausgang 17 des Umschalters 16 mit dessen zweiten Eingang 19 verbunden hält, solange die beiden Eingangssignale der Vergleichsstufe 15 übereinstimmen, daß sie den Ausgang 17 aber mit dem ersten Eingang 18 verbindet, wenn die Signale an den Eingängen voneinander abweichen.

Das Mikroprozessorprogramm steuert die Niederfrequenzstufe in der im folgenden beschriebenen Weise.

Im Augenblick des Ausschaltens steht das Potentiometer 6 in der der gewünschten Lautstärke entsprechenden Stellung. Diese Stellung ist in dem RAM-Speicher 10 digital gespeichert. Beim Ausschalten der Stromversorgung 8 wird die erste Torschaltung 11 für die Dauer eines von dem Schalter 7 abgeleiteten Einschaltimpulses geöffnet. Dabei übernimmt der E²PROM-Speicher 12 den Inhalt des ersten Speichers 10. Dieser zweite Speicher 12 hält den Einstellwert des Potentiometers beim Ausschalten während der anschließenden stromlosen Phase gespeichert.

Beim Wiedereinschalten des Rundfunkempfängers öffnet ein vom Schalter 7 abgeleiteter Einschaltimplus während seiner Dauer die zweite Torschaltung 13. Dabei übernimmt der dritte Speicher 14, der wiederum ein RAM-Speicher sein kann, den Inhalt des Speichers 10, der die Einstellung des Potentiometers im Zeitpunkt der Einschaltung wiedergibt. Diese Einstellung kann durchaus unbeabsichtigt sein und bleibt in dem dritten Speicher 14 auch dann gespeichert, wenn sich später die Einstellung des Potentiometers 6 ändert.

Nach dem Einschaltimpuls stimmen die Inhalte der beiden Speicher 10 und 14 überein. Damit sind die Eingangssignale der Vergleichsstufe 15 identisch und der Ausgang 17 des Umschalters 16 wird über den zweiten Eingang 19 in Verbindung mit dem Ausgang des zweiten Speichers 12 gehalten.

In diesen Speicher 12 ist jedoch - wie bereits erwähnt - die Lautstärke gespeichert, auf die das Potentiometer beim Ausschalten des Rundfunkempfängers eingestellt war. Eine unbeabsichtigte Verstellung des Potentiometers 6 während der Ausschaltphase bleibt daher beim Einschalten ohne Einfluß auf die Wiedergabelautstärke.

Diese Umschalterstellung bleibt solange erhalten, bis der Hörer eine Änderung der Einstellung des Abgriffs des Potentiometers vornimmt. In diesem Zeitpunkt ändert sich der Inhalt des ersten Speichers 10, in dem jeweils die momentane Potentiometerstellung digital abgelegt ist, gegenüber dem Inhalt des dritten Speichers 14, der die Einschaltstellung des Potentiometers 6 enthält. Diese Abweichung zeigt an, daß der Hörer momentan die erste Änderung der Lautstärke nach dem Einschalten herbeiführen will. Die Vergleichsstufe 15 erkennt den Eintritt der Ungleichheit der Inhalte der Speicher 10 und 14 und verbindet im Umschalter 16 nunmehr dessen Ausgang 17 mit seinem ersten Eingang 18, der mit dem Ausgang des ersten Speichers 10 verbunden ist. Von nun an bestimmt nicht mehr der Inhalt des zweiten Speichers 12, sondern der Inhalt des ersten Speichers 10 die Verstärkung des Endverstärkers 1, d. h. die momentane Potentiometerstellung.

Danach kann der Inhalt des dritten Speichers 14 gelöscht werden.

Die beschriebene Schaltung verzögert mithin das Wirksamwerden der momentanen Potentiometerstellung für die Lautstärke des Endverstärkers 1 nach dem Einschalten, bis die Hand des Hörers den Potentiometerabgriff verstellt. Da der Hörer zu dieser Zeit auf eine Lautstärkeänderung eingestellt ist, wird er einen über seine Vorstellung hinausgehenden Lautstärkeanstieg als Folge einer eigenen falschen Bedienung des Potentiometers interpretieren und sofort gegensteuern. Eine solche über die Erwartung hinausgehende Lautstärkeanhebung ist immer dann gegeben, wenn in der Ausschaltphase das Potentiometer zum rechten Anschlag hin verstellt worden ist.

Die vorstehend beschriebene Schaltung verschiebt somit das Wirksamwerden einer unbeabsichtigten Verstellung des Potentiometerabgriffs während der Ausschaltphase von dem Einschaltzeitpunkt der Niederfrequenzstufe weg zu einem Zeitpunkt, in dem der Hörer die gehörte Lautstärke ändern will und unmittelbar auf eine unerwartete Änderung reagieren kann.

Im NF-Steller 3 entsteht bei ungünstigen Verhältnissen, wenn z. B. das Potentiometer an den rechten Anschlag gedreht wurde, ein plötzlicher großer Anstieg der Lautstärke, wenn die Potentiometerstellung nach dem Einschalten erstmals geändert wird. Zur Vermeidung einer schlagartigen Lautstärkeanhebung ist daher hinter dem Ausgang 17 des Umschalters 16 ein Tiefpaß 21 angeordnet. Dieser bewirkt einen langsamen Anstieg der Lautstärke auf die momentane Potentiometerstellung.

Dieser Tiefpaß wird im Falle einer Prozessorsteuerung durch kontinuierliche, die Lautstärke ändernde Signale dargestellt.

In dem Ausführungsbeispiel ist das Mikroprozessorprogramm derart ausgelegt, daß die Schnelligkeit des Anstiegs der Lautstärke von der momentanen Stellung des Potentiometerabgriffs abhängig ist, und zwar in der Weise, daß der Anstieg der Lautstärke bei großer Lautheit des Lautsprechers langsamer erfolgt als bei einer Stummschaltung.

## Patentansprüche

1. Rundfunkempfänger mit einem Potentiometer als Lautstärkesteller und zumindest einem unabhängig von dem Potentiometer bedienbaren Schalter in der Stromversorgung,
dadurch gekennzeichnet,
daß die Lautstärke der Endstufe (1) beim Einschalten des Schalters (7) auf dem Wert gehalten bleibt, auf den das Potentiometer (6) beim Ausschalten eingestellt war,
und daß die Lautstärke beim Einschalten einer zwischenzeitlichen Potentiometerverstellung erst nachgeführt wird, wenn die Potentiometerstellung nach dem Einschalten erstmals verändert wird.

2. Rundfunkempfänger nach Anspruch 1, mit einem programmgesteuerten Mikroprozessor,
dadurch gekennzeichnet,
daß während des Programmablaufs dem Abgriff des Potentiometers (6) ein A/D-Wandler (9) nachgeschaltet ist, der mit dem Eingang eines ersten Speichers (10) verbunden ist, daß der Inhalt des ersten Speichers (10) beim Ausschalten des Schalters (7) in einen zweiten Speicher (12) und beim Einschalten des Schalters (7) in einen dritten Speicher (14) übertragen wird, daß der Ausgang des ersten Speichers (10) mit einem ersten Eingang (18) eines Umschalters (16) verbunden ist und daß der zweite Eingang (19) des Umschalters (16) an den Ausgang des zweiten Speichers (12) angeschlossen ist, daß ferner der Ausgang (17) des Umschalters (16) mit dem Eingang eines digital steuerbaren NF-Stellers (3) verbunden ist und der Steuereingang (20) des Umschalters an den Ausgang einer Vergleichsstufe (15) angeschlossen ist, deren erster Eingang mit dem Ausgang des ersten Speichers (10) und deren zweiter Eingang mit dem Ausgang des dritten Speichers (14) verbunden ist, und daß im Programmablauf der Ausgang (17) des Umschalters (16) mit seinem zweiten Eingang (19) verbunden bleibt, solange die Inhalte des ersten Speichers (10) und des dritten Speichers (14) übereinstimmen und der Ausgang (17) mit dem ersten Eingang (18) verbunden wird, sobald die Inhalte des ersten Speichers (10) und dritten Speichers (14) nicht mehr übereinstimmen.

3. Rundfunkempfänger nach Anspruch 1 oder 2,
dadurch gekennzeichnet,
daß die Endstufe (1) einen Endverstärker (1) hat, der kontinuierlich bis zu der dem Inhalt des Speichers (10) entsprechenden Lautstärke eingestellt wird, wenn der Ausgang (17) des Umschalters (16) mit seinem ersten Eingang (18) verbunden ist.

4. Rundfunkempfänger nach Anspruch 2,
gekennzeichnet
durch einen digitalen Tiefpaß (21) im Ausgang (17) des Umschalters (16).

5. Rundfunkempfänger nach Anspruch 3 oder 4,
dadurch gekennzeichnet,
daß die Endstufe (1) einen Endverstärker (1) hat und daß die Einstellung des Endverstärkers (1) im Bereich hoher Lautstärke langsamer als im Bereich geringer Lautstärke verändert wird.

6. Rundfunkempfänger nach Anspruch 4,
dadurch gekennzeichnet,
daß der Tiefpaß (21) von der eingestellten Lautstärke steuerbar ist.

## Claims

1. Broadcast radio receiver having a potentiometer as a volume control, and having at least one switch, which can be operated independently from the potentiometer, in the power supply,
characterized
in that the volume of the output stage (1) when the switch (7) is switched on remains at the level at which the potentiometer (6) was set when the switch was switched off,
and in that, if the potentiometer has been moved in the meantime, the volume does not follow this change when the switch is switched on until the potentiometer position is changed for the first time after switching on the switch.

2. Broadcast radio receiver according to Claim 1, having a programmable microprocessor,
characterized
in that, while the programme is running, an A/D converter (9) is connected downstream of the tap on the potentiometer (6) and is connected to the input of a first memory (10), in that the contents of the first memory (10) are transferred to a second memory (12) when the switch (7) is switched off, and are transferred to a third memory (14) when the switch (7) is switched on, in that the output of the first memory (10) is connected to a first input (18) of a changeover switch (16), and in that the second input (19) of the changeover switch (16) is connected to the output of the second memory (12), in that, furthermore, the output (17) of the changeover switch (16) is connected to the input of a digitally controllable AF controller (3), and the control input (20) of the changeover switch is connected to the output of a comparison stage (15) whose first input is connected to the output of the first memory (10) and whose second input is connected to the output of the third memory (14), and in that, while the programme is running, the output (17) of the changeover switch (16) remains connected to its second input (19) as long as the contents of the first memory (10) and of the third memory (14) match, and the output (17) is connected to the first input (18) as soon as the contents of the first memory and of the third memory (14) no longer match.

3. Broadcast radio receiver according to Claim 1 or 2,
characterized
in that the output stage (1) has an output amplifier (1) which is continuously adjusted until the volume corresponds to the contents of the memory (10) when the output (17) of the changeover switch (16) is connected to its first input (18).

4. Broadcast radio receiver according to Claim 2,
characterized
by a digital low-pass filter (21) in the output (17) of the changeover switch (16).

5. Broadcast radio receiver according to Claim 3 or 4,
characterized in that
the output stage (1) has an output amplifier (1), and in that the setting of the output amplifier (1) is varied more slowly in the region where the volume is high than in the region where the volume is low.

6. Broadcast radio receiver according to Claim 4,
characterized
in that the low-pass filter (21) can be controlled by the volume setting.

## Revendications

1. Récepteur radio comportant un potentiomètre pour régler le volume et au moins un interrupteur commandé indépendamment du potentiomètre dans l'alimentation électrique,
caractérisé en ce que
lors du branchement de l'interrupteur (7), le volume de l'étage de puissance (1) est maintenu à une valeur à laquelle le potentiomètre (6) était réglé au moment de coupure et, le volume lors du branchement d'une modification de réglage intermédiaire du potentiomètre est d'abord asservi si le réglage du potentiomètre a été modifié une première fois après le branchement.

2. Récepteur radio selon la revendication 1 comportant un microprocesseur commandé par programme,
caractérisé en ce que
pendant le déroulement du programme, le curseur du potentiomètre (6) est suivi d'un convertisseur A/N (9) relié à l'entrée d'une première mémoire (10), le contenu de la première mémoire (10) est transféré à la coupure de l'interrupteur (7) dans une seconde mémoire (12), et au branchement de l'interrupteur (7) dans une troisième mémoire (14), la sortie de la première mémoire (10) est reliée à la première entrée (18) d'un commutateur (16) et, la seconde entrée (19) du commutateur (16) est reliée à la sortie de la seconde mémoire (12), en outre la sortie (17) du commutateur (16) est reliée à l'entrée d'un actionneur BF (3) à commande numérique et l'entrée de commande (20) du commutateur est reliée à la sortie d'un comparateur (15), dont la première entrée est reliée à la sortie de la première mémoire (10) et la seconde entrée est reliée à la sortie de la troisième mémoire (14) et, au cours du déroulement du programme, la sortie (17) du commutateur (16) est reliée à sa seconde entrée (19) aussi longtemps que les contenus de la première mémoire (10) et de la troisième mémoire (14) se correspondent et, la sortie (17) est reliée à la première entrée (18) dès que le contenu de la première mémoire (10) et celui de la troisième mémoire (14) ne se correspondent plus.

3. Récepteur radio selon la revendication 1 ou 2,
caractérisé en ce que
l'étage de puissance (1) a un amplificateur de puissance qui se règle en continu jusqu'au volume correspondant au contenu de la mémoire (10) lorsque la sortie (17) du commutateur (16) est reliée à sa première entrée (18).

4. Récepteur radio selon la revendication 2,
caractérisé par
un filtre passe-bas numérique (21) à la sortie (17) du commutateur (16) .

5. Récepteur radio selon la revendication 3 ou 4,
caractérisé en ce que
l'étage de puissance (1) a un amplificateur de puissance et le réglage de l'amplificateur de puissance (1) au niveau des volumes élevés se fait plus lentement que pour les volumes faibles.

6. Récepteur radio selon la revendication 4,
caractérisé en ce que
le filtre passe-bas (21) est commandé à partir d'un volume réglé.
